# EUROPÄISCHE PATENTANMELDUNG

(11) **EP 0 564 447 A1**
(43) Veröffentlichungstag der Anmeldung: **06.10.1993**
(21) Anmeldenummer: 93890071.9
(22) Anmeldetag: 05.04.1993
(51) Int. Cl.: H05K 13/08, H01L 21/68, B23Q 16/00

(54) **Positioniereinrichtung bei der Bestückung von Leiterplatten**

(30) Priorität: 03.04.1992 AT 705/92
(71) Anmelder: Alcatel Austria Aktiengesellschaft, A-1210 Wien (AT)
(72) Erfinder: Thürnbeck, Johann, Mag.,Dipl.Ing.,Dr.,Dr., A-1210 Wien (AT)

(57) **Zusammenfassung**

Zur Feinpositionierung insbesonders eines elektronischen Bauelementes (1) auf einer Leiterplatte (3) ist ein Elementträger (5) vorgesehen, der an zumindest drei Angreifstellen (6) an in ihrer Länge variablen, im wesentlichen linear ausgerichteten Übertragungselementen (7) angreift, deren gelenkige Befestigungsstellen (8) jeweils einerseits an einem bewegbaren Führungsteil (9) und andererseits an einem feststehenden Stativteil (10) liegen. Damit kann die weitgehend freie Beweglichkeit des Führungsteils (9) entsprechend untersetzt auf den Elementträger (5) und damit das zu positionierende Bauelement (1) übertragen werden.

## Beschreibung

Die Erfindung betrifft eine Einrichtung zur Positionierung eines Elementes, insbesonders eines elektronischen Bauelementes auf einer Leiterplatte, mit einem bewegbaren Elementträger, der eine steuerbare Halteeinrichtung für das Element aufweist.

Im Zuge der immer weiter fortschreitenden Miniaturisierung einzelner Bauelemente auf verschiedensten technischen Gebieten, wie insbesonders der elektronischen Bauelemente, die auf einer Leiterplatte angeordnet und zumeist gleichzeitig mit ihrer Befestigung über die Anschlußfüße auch kontaktiert sind, steigen auch die Anforderungen an die Genauigkeit der Positionierung derartiger Bauelemente. So sind beispielsweise neuere Generationen von sogenannten Fine-Pitch-Bauelementen für hochpolige SMD (Surface Mounted Devices)-Komponenten bereits mit Anschlußrastern von 0,2 mm und kleiner ausgebildet, was entsprechende Positionierungsgenauigkeiten bis zu etwa ± 25 µm erfordert. Ein derartiger Positioniervorgang, der sowohl.bei der erstmaligen Bestückung der Leiterplatte, als auch bei einem späteren Austausch von fehlerhaften Bauelementen notwendig ist, weist im allgemeinsten Fall sechs Freiheitsgrade auf, wobei von den bekannten SMD-Bestückungseinrichtungen nur vier beherrscht werden; nämlich x, y, z und der Drehwinkel um die z-Achse.

Probleme gibt es bei den bekannten Positioniereinrichtungen insbesonders dann, wenn Durchbiegungen, Unebenheiten, oder dergleichen, der Fläche, auf der das jeweilige Element positioniert werden soll, gegeben sind, da insbesonders die angesprochenen hochpoligen Fine-Pitch-Bauelemente dann nicht mit der erforderlichen Genauigkeit sicher plaziert werden können.

Bei neuartigen Erstbestückungsautomaten ist im zuletzt genannten Zusammenhang bekannt geworden, die angesprochenen Kippwinkeleinstellungen mit einem sphärisch beweglichen Bestückungskopf zu ermöglichen, was allerdings einerseits eine relativ aufwendige Konstruktion und andererseits einen erhöhten Steuerungsaufwand bedeutet, sodaß - neben den sonstigen Schwierigkeiten mit der Neuprogrammierung derartiger Automaten - ein Einsatz für einen späteren Austausch einzelner Elemente oder für Kleinserien nicht sinnvoll möglich ist.

Aufgabe der vorliegenden Erfindung ist es, die genannten Nachteile der bekannten Einrichtungen der eingangs genannten Art zu vermeiden und insbesonders auf einfache Weise eine genaue und sichere Plazierung eines zu positionierenden Elementes auch dann zu erlauben, wenn die Fläche auf der das Element zu plazieren ist uneben ist, bzw. auch wenn es sich nur um ein nachträglich auszutauschendes Bauelement handelt.

Diese Aufgabe wird gemäß der vorliegenden Erfindung bei einer Einrichtung der eingangs genannten Art dadurch gelöst, daß der Elementträger an zumindest drei Angreifstellen an in ihrer Länge variablen, im wesentlichen linear ausgerichteten Übertragungselementen angreift, deren gelenkige Befestigungsstellen jeweils einerseits an einem bewegbaren Führungsteil und andererseits an einem feststehenden Stativteil liegen. Damit ist auf einfache Weise einerseits eine in weiten Grenzen beliebige Untersetzung der Bewegung des Führungsteiles auf die für die Positionierung relevante Bewegung des Elementträgers und andererseits eine weitestgehend freie Bewegung des Elementträgers - inklusive kippen bzw. drehen um alle drei Achsen - ermöglicht. Die einzelnen Bewegungsfreiheiten sind dabei im wesentlichen nur durch die Bewegungsfreiheiten des Führungsteiles bzw. von dessen Betätigung begrenzt, wobei das absolute Ausmaß der einzelnen Bewegungsfreiheiten des Elementträgers über das jeweils gegebene Untersetzungsverhältnis mit der entsprechenden Bewegungsfreiheit des Führungsteiles gekoppelt ist.

Gemäß einer bevorzugten Ausgestaltung der Erfindung ist vorgesehen, daß die Übertragungselemente von längskontrahierbaren Federelementen, vorzugsweise Schraubenfedern, gebildet sind. Für die Zwecke der Erfindung bevorzugt geeignet sind natürlich solche Übertragungselemente, die sich bei einer Längenänderung über ihre ganze Länge entsprechend ändern (also nicht etwa nur zwei ineinander schiebbare teleskopartige Elemente aufweisen), da dann eine Untersetzung der Bewegung des Führungsteiles unabhängig von der Lage der Angreifstelle relativ zum Übertragungselement insgesamt erfolgt. In diesem Sinne geeignet für die Zwecke der Erfindung sind also beispielsweise auch nach Art eines Scherengitters ausziehbare Übertragungselemente, oder eben die vorzugsweise angeführten Schraubenfedern, bei denen die angeführte gelenkige Befestigung natürlich auch durch die Biegsamkeit der ansonsten z.B. fest eingespannten Federenden selbst realisiert sein kann.

Die Übertragungselemente können in weiterer Ausgestaltung der Erfindung im wesentlichen radial um den Elementträger angeordnet und in einer Ebene bzw. auf einem Kegelmantel ausgerichtet sein, womit sich relativ einfache konstruktive Verhältnisse bei einfacher Handhabbarkeit und brauchbaren Untersetzungsbedingungen ergeben. Davon abgesehen könnte für verschiedene Anwendungsfälle aber natürlich auch eine andere Anordnung bzw. Ausrichtung der Übertragungselemente, beispielsweise auf einem Zylindermantel, vorteilhaft sein.

Nach einer besonders bevorzugten Ausgestaltung der Erfindung sind die Angreifstellen relativ zu den Befestigungsstellen der Übertragungselemente verstellbar, womit sich die Untersetzung insgesamt, bzw. auch die Untersetzung einzelner Freiheitsgrade unterschiedlich voneinander, sehr leicht ändern und den jeweiligen Erfordernissen anpassen läßt.

Der Führungsteil ist gemäß einer weiteren Ausgestaltung der Erfindung im wesentlichen ringförmig und von Hand bewegbar, was insbesonders im Zusammenhang mit den eingangs angesprochenen nachträglichen Manipulationen beispielsweise zum Austausch von fehlerhaften Bauelementen sehr einfach, schnell und damit vorteilhaft ist. Die Kontrolle der tatsächlichen Positionierung des jeweiligen Elementes kann dabei wie bekannt beispielsweise über ein Mikroskop, oder eine Videoeinrichtung od. dgl. erfolgen.

Der Stativteil und/oder der Führungsteil kann nach einer weiteren bevorzugten Ausgestaltung der Erfindung Füße aufweisen, die vorzugsweise separat verstellbar sind. Damit kann beispielsweise der Führungsteil relativ zum Stativteil in einer bestimmten Schräglage abgestellt bzw. abgestützt werden, was einer schrägen Vorpositionierung des Elementträgers und damit des zu positionierenden Elementes entspricht. Darüber hinaus kann der Stativteil mittels seiner Füße beispielsweise auf eine zu bestückende Leiterplatte gestellt werden, wobei über die separate Verstellbarkeit der Füße wiederum eine Anpassung an örtliche Unebenheiten oder dergleichen möglich ist.

Der Stativteil kann nach einer anderen Weiterbildung der Erfindung um den Bereich des zu positionierenden Elementes eine Schutzschürze aufweisen, was insbesonders beispielsweise beim nachträglichen Einlöten eines ausgetauschten Bauelementes auf einer ansonsten fertig bestückten Leiterplatte sehr vorteilhaft ist, da die Beeinflussung benachbarter Lötstellen beispielsweise bei Heißluftlötung ausgeschlossen werden kann.

Der Stativteil und/oder der Führungsteil kann in weiterer Ausgestaltung der Erfindung über eine Verstellanordnung, vorzugsweise mittels gesteuerter Stellmotoren, bewegbar sein, was eine Automation der erfindungsgemäßen Einrichtung und eine Ausnutzung der beschriebenen Bewegungsuntersetzung auch im Zusammenhang mit einer motorischen Verstellung zur Erhöhung der Positioniergenauigkeit ermöglicht.

Nach einer weiteren Ausbildung der Erfindung ist der Elementträger über einzelne Verbindungsstege, von denen bevorzugt zumindest einer hohl ausgebildet ist, mit den die Angreifstellen aufweisenden Bereichen verbunden. Über den hohlen Verbindungssteg kann sehr einfach beispielsweise eine Saugleitung zur Erzeugung von Vakuum am Aufnahmebereich des Elementträgers geführt werden, ohne daß die ansonsten erforderliche Leitung die Positionierbewegung behindert. Durch den zwischen den einzelnen Verbindungsstegen freien Querschnitt ist eine weitgehend freie Sicht zur Kontrolle der Positionierung sowie auch beispielsweise der Durchtritt von Heißluft, Laserlicht oder dergleichen für die Lötung eines positionierten Elementes möglich.

Der Elementträger kann in weiterer Ausgestaltung der Erfindung auch mit zumindest einer Angriffsfläche zur Aufbringung eines Belastungsgewichtes bzw. für den Angriff einer Belastungsanordnung ausgebildet sein, was nach erfolgter Positionierung eines Elementes dessen sichere Festlegung beispielsweise während der Lötung ermöglicht.

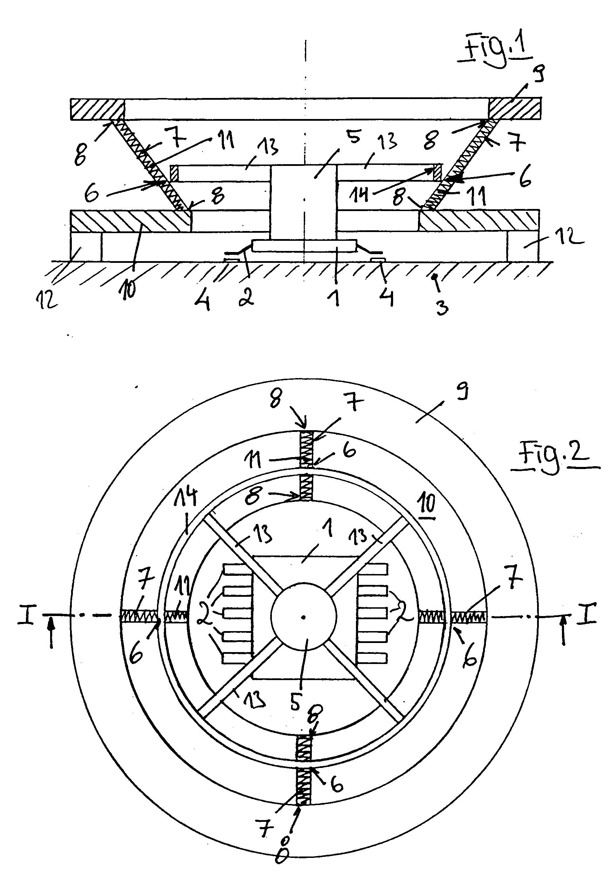

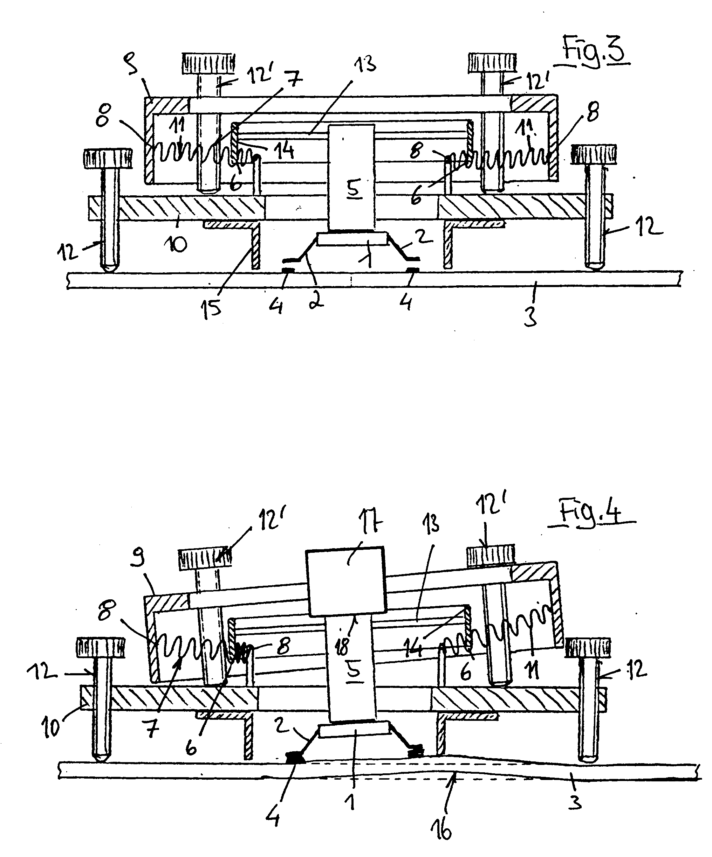

Die Erfindung wird im folgenden noch anhand der in der Zeichnung schematisch dargestellten Ausführungsbeispiele näher erläutert. Fig. 1 zeigt dabei einen Schnitt durch eine erfindungsgemäße Einrichtung entlang der Linie I-I in Fig. 2, Fig. 2 eine Draufsicht auf die Einrichtung gemäß Fig. 1 von oben, Fig. 3 einen in der Schnittführung der Darstellung nach Fig. 1 entsprechenden Schnitt durch ein anderes Ausführungsbeispiel und Fig. 4 die Einrichtung nach Fig. 3 in einer anderen Betriebsstellung.

Die in Fig. 1 und 2 in Form einer Prinzipskizze dargestellte Einrichtung nach der Erfindung dient zur Positionierung eines mit Anschlußfüßen 2 zur Befestigung und Kontaktierung versehenen elektronischen Bauelementes 1 auf einer Leiterplatte 3, wobei die Anschlußfüße 2 möglichst genau mit Landeflächen 4 auf der Leiterplatte 3 in Übereinstimmung gebracht werden müssen. Nach dieser Positionierung kann auf hier nicht weiter interessierende Weise eine mechanisch stabile, elektrisch leitende Verbindung zwischen den Anschlußfüßen 2 und den Landeflächen 4 hergestellt werden, beispielsweise durch Heißluft-Verlötung.

Da im Gegensatz zur schematischen Darstellung in den Fig. 1 und 2 in Wirklichkeit heutzutage wesentlich mehr Anschlußfüße 2 mit wesentlich geringeren Breiten und Abständen Verwendung finden (sogenannte Fine-Pitch-Elemente weisen bereits Anschlußfußbreiten und -abstände im Bereich von 0,2 mm und darunter auf), kommt der richtigen Positionierung des Bauelementes 1 entscheidende Bedeutung zu. Die erforderlichen Genauigkeiten für diese Positionierung liegen bei den genannten Fine-Pitch-Elementen im Bereich von 25 µm und darunter.

Um diese hohe Positioniergenauigkeit auch unabhängig von konstruktiv aufwendigen und nur mit relativ umfangreichen Maßnahmen für einzelne Positionieraufgaben umzustellenden bzw. umzurüstenden modernen Bestückungsautomaten bereitstellen zu können, ist bei der dargestellten Einrichtung der bewegbare Elementträger 5, der eine hier nicht weiter interessierende, steuerbare Halteeinrichtung (beispielsweise einen Vakuumanschluß zum steuerbaren Festhalten des Bauelementes 1) aufweist, an vier Angreifstellen an in ihrer Länge variablen, im wesentlichen linear ausgerichteten Übertragungselementen 7 anliegend, deren gelenkige Befestigungsstellen 8 jeweils einerseits an einem bewegbaren Führungsteil 9 und andererseits an einem feststehenden Stativteil 10 liegen. Die Übertragungselemente 7 sind hier von längskontrahierbaren Federelementen, ausgeführt als Schraubenfedern 11, gebildet; weiters geeignet wären z.B. auch gelenkig befestigte, scherengitterartige Elemente, oder Gummi- bzw. Elastikschnüre oder dergleichen. In der dargestellten Ausführung sind die Übertragungselemente 7 radial um den Elementträger 5 angeordnet und auf einem Kegelmantel ausgerichtet - bedarfsweise ohne weiteres möglich wäre aber auch die Anordnung bzw. Ausrichtung der Übertragungselemente 7 in einer Ebene (siehe z.B. Fig. 3 und 4) oder auch auf einem stehenden Zylinder oder dergleichen.

Zum Positionieren des Bauelementes 1 auf der Leiterplatte 3, bzw. der Anschlußfüße 2 auf den Landeflächen 4, wird der Stativteil 10 mitsamt den Übertragungselementen 7, dem Führungsteil 9, und dem Elementträger 5 mit Bauelement 1 an Füßen 12 auf der Oberfläche der Leiterplatte 3 aufgestellt, wobei eine grobe Vorpositionierung unter Sichtkontrolle von oben her erfolgt. Sodann kann mittels in weiten Grenzen freier Bewegung des ringförmigen Führungsteils 9 eine entsprechend untersetzte Bewegung des über Verbindungsstege 13 mit den hier auf einem Ringteil 14 ausgebildeten Angreifstellen 6 in Verbindung stehenden Elementträgers 5 bewirkt werden, bis das zu positionierende Bauelement 1 an der exakt richtigen Position durch entsprechendes Absenken des Führungsteils 9 plaziert werden kann. Nach dem Lösen der steuerbaren Halteeinrichtung für das Bauelement 1, das beispielsweise erst nach durchgeführter Befestigung, beispielsweise durch Lötung, des Bauelementes 1 erfolgt, kann die gesamte Einrichtung wieder einfach entfernt werden.

Das Ausmaß der Untersetzung der Bewegung des Führungsteils 9 auf den Ringteil 14 und damit den Elementträger 5 ist unmittelbar abhängig von der relativen Lage jeder der Angreifstellen 6 bezüglich der zugehörigen Befestigungsstellen 8 am Führungsteil 9 einerseits und am Stativteil 10 andererseits. Je näher die einzelne Angreifstelle 6 zur Befestigungsstelle 8 am Stativteil 10 liegt, desto größer ist die Untersetzung, d.h. also, desto kleiner wird die bei einer bestimmten Bewegung des Führungsteils 9 erfolgende Bewegung des Elementträgers 5. Je näher andererseits die Angreifstelle 6 an der Befestigungsstelle des zugehörigen Übertragungselementes 7 am Führungsteil 9 liegt, desto mehr wirkt sich eine Bewegung des Führungsteils 9 in einer zugehörigen Bewegung des Elementträgers 5 aus. Zumindest theoretisch liegt der Bereich des realisierbaren Untersetzungsverhältnisses zwischen eins (Angreifstelle 6 fällt mit der oberen Befestigungsstelle 8 am Führungsteil 9 zusammen) und unendlich (Angreifstelle 6 fällt mit der unteren Befestigungsstelle am Stativteil 10 zusammen). Abgesehen von der Möglichkeit Elementträger 5 mit unterschiedlich lang ausgebildeten Verbindungsstegen 13 und damit unterschiedlich großen Durchmessern des Ringteiles 14 zu verwenden, könnten die Angreifstellen 6 aber auch auf hier nicht dargestellte Weise relativ zum Elementträger 5 verstellbar sein, beispielsweise über Gewindestangen oder dergleichen. Damit könnte auf einfache Weise auch eine voneinander unabhängige Verstellbarkeit der Angreifstellen 6 relativ zu den zugehörigen Übertragungselementen 7 und damit eine unterschiedliche Untersetzung der einzelnen Freiheitsgrade erreicht werden.

Bei der erfindungsgemäßen Einrichtung nach den Fig. 3 bzw. 4 sind von der Ausbildung bzw. Funktion her den Fig. 1 und 2 entsprechende Bauteile wieder mit gleichen Bezugszeichen versehen. Zur Beschreibung der Ausbildung und Funktion dieser Teile wird daher auch ausdrücklich auf die obenstehenden Ausführungen zu Fig. 1 und 2 verwiesen.

Die wesentlichen Änderungen der Einrichtung nach den Fig. 3 und 4 sind nur darin zu sehen, daß hier nun einerseits die wiederum als Spiralzugfeder 11 ausgebildeten Übertragungselemente 7 im wesentlichen in einer Ebene rund um den Elementträger 5 liegen und daß andererseits verstellbare Füße 12 für den Stativteil 10 und 12' für den Führungsteil 9 vorgesehen sind, wobei der Stativteil 10 mit seinen Füßen 12 wiederum auf der Leiterplatte 3 abgestellt werden kann; der Führungsteil 9 kann über seine verstellbaren Füße 12' auf der Oberseite des Stativteiles 10 abgestellt werden. Weiters ist hier noch eine Schutzschürze 15 an der Unterseite des Stativteils 10 vorgesehen, welche den Bereich des zu positionierenden Elementes 1 umschließt und damit, beispielsweise bei Heißluftlötung von oben her, angrenzende, hier nicht dargestellte elektronische Bauelemente und deren Befestigung schützt.

Gemäß Fig. 4 sind die Füße 12' des Führungsteils 9, die ebenso wie die Füße 12 des Stativteils 10 als Rändelschrauben ausgebildet sind, jeweils unterschiedlich weit in die zugehörigen Gewinde eingeschraubt, was zu einer Schrägstellung des auf dem Stativteil 10 abgestellten Führungsteils 9 führt. Dies ergibt - mit der entsprechenden Untersetzung - eine schräge Vorpositionierung des Elementträgers 5 und damit des zu positionierenden Bauelementes 1 gegenüber der Leiterplatte 3, sodaß beispielsweise eine hier schematisch angedeutete Verwölbung 16 im Bereich der Landeflächen 4 bereits vorweg berücksichtigt werden kann. Auf ähnliche Weise kann über die Verstellbarkeit der Füße 12 des Stativteils 10 auch eine Berücksichtigung von Unebenheiten oder dergleichen auf der Leiterplatte außerhalb des Bereiches des zu positionierenden Bauelementes erfolgen.

In Fig. 4 ist schließlich noch ein Belastungsgewicht 17 auf einer oberen Angriffsfläche 18 des Elementträgers 5 dargestellt, welches nach erfolgter Positionierung des Bauelementes 1 aufgelegt werden kann, um dieses beispielsweise während der nachfolgenden Lötung sicher zu halten. Davon abgesehen wäre aber natürlich auch eine andere hier nicht dargestellte Belastungsanordnung für diesen Zweck möglich. Vorteilhaft ist dabei, wenn zumindest einer der Verbindungsstege 13 hohl ausgeführt ist, da dann beispielsweise ein Vakuumanschluß für die Halteeinrichtung des Elementträgers 5 über diesen Verbindungssteg 13 geführt werden kann und die Oberseite des Elementträgers 5 für die genannte Angriffsfläche 18 frei bleibt.

Abgesehen von der auch bei der Einrichtung nach den Fig. 3 und 4 vorgesehenen Vorpositionierung des Stativteils 10 bzw. Feinpositionierung über den Führungsteil 9 von Hand aus könnte aber für den Stativteil und/oder den Führungsteil auch eine Verstellanordnung beispielsweise mittels gesteuerter Stellmotoren vorgesehen werden, was die Ausnutzung der vorteilhaften Positionierungsmöglichkeiten der dargestellten Einrichtung auch im Zusammenhang mit einer motorischen Verstellung erlaubt.

## Patentansprüche

1. Einrichtung zur Positionierung eines Elementes, insbesonders eines elektronischen Bauelementes auf einer Leiterplatte, mit einem bewegbaren Elementträger, der eine steuerbare Halteeinrichtung für das Element aufweist, **dadurch** **gekennzeichnet**, daß der Elementträger (5) an zumindest drei Angreifstellen (6) an in ihrer Länge variablen, im wesentlichen linear ausgerichteten Übertragungselementen (7) angreift, deren gelenkige Befestigungsstellen (8) jeweils einerseits an einem bewegbaren Führungsteil (9) und andererseits an einem feststehenden Stativteil (10) liegen.

2. Einrichtung nach Anspruch 1, dadurch gekennzeichnet, daß die Übertragungselemente (7) von längskontrahierbaren Federelementen, vorzugsweise Schraubenfedern (11), gebildet sind.

3. Einrichtung nach Anspruch 1 oder 2, dadurch gekennzeichnet, daß die Übertragungselemente (7) im wesentlichen radial um den Elementträger (5) angeordnet und in einer Ebene bzw. auf einem Kegelmantel ausgerichtet sind.

4. Einrichtung nach einem der Ansprüche 1 bis 3, dadurch gekennzeichnet, daß die Angreifstellen (6) relativ zu den Befestigungsstellen (8) der Übertragungselemente (7) verstellbar sind.

5. Einrichtung nach einem der Ansprüche 1 bis 4, dadurch gekennzeichnet, daß der Führungsteil (9) im wesentlichen ringförmig und von Hand bewegbar ist.

6. Einrichtung nach einem der Ansprüche 1 bis 5, dadurch gekennzeichnet, daß der Stativteil (10) und/oder der Führungsteil (9) Füße (12,12') aufweist, die vorzugsweise separat verstellbar sind.

7. Einrichtung nach Anspruch 6, dadurch gekennzeichnet, daß der Stativteil (10) um den Bereich des zu positionierenden Elementes (1) eine Schutzschürze (15) aufweist.

8. Einrichtung nach einem der Ansprüche 1 bis 4, dadurch gekennzeichnet, daß der Stativteil (10) und/oder der Führungsteil (9) über eine Verstellanordnung, vorzugsweise mittels gesteuerter Stellmotoren, bewegbar ist.

9. Einrichtung nach einem der Ansprüche 3 oder 4, dadurch gekennzeichnet, daß der Elementträger (5) über einzelne Verbindungsstege (13), von denen bevorzugt zumindest einer hohl ausgebildet ist, mit den die Angreifstellen (6) aufweisenden Bereichen verbunden ist.

10. Einrichtung nach Anspruch 9, dadurch gekennzeichnet, daß der Elementträger (5) mit zumindest einer Angriffsfläche (18) zur Aufbringung eines Belastungsgewichtes (17) bzw. für den Angriff einer Belastungsanordnung ausgebildet ist.
